# EUROPÄISCHE PATENTSCHRIFT

(11) **EP 0 428 222 B1**
(45) Veröffentlichungstag und Bekanntmachung des Hinweises auf die Patenterteilung: **19.05.1993**
(21) Anmeldenummer: 90202982.6
(22) Anmeldetag: 12.11.1990
(51) Int. Cl.: H03B 5/36, H03K 3/283

(54) **Quarzobertonoszillator**
Harmonic crystal oscillator
Oscillateur à quartz à harmoniques

(30) Priorität: 16.11.1989 DE 3938095
(43) Veröffentlichungstag der Anmeldung: 22.05.1991
(73) Patentinhaber: Philips Patentverwaltung GmbH, 22335 Hamburg (DE); Philips Electronics N.V., 5621 BA Eindhoven (NL)
(72) Erfinder: Kohsiek, Cord Heinrich, W-2086 Ellerau (DE)
(74) Vertreter: von Laue, Hanns-Ulrich, Dipl.-Ing.

(56) Entgegenhaltungen:
- DE-A- 3 136 696
- GB-A- 1 113 157
- US-A- 3 743 968
- US-A- 3 916 345
- ELEKTOR, Band 9, Nr. 7/8, Juli/August 1983, Seite 7-31; "Symmetrical harmonic oscillator"

## Beschreibung

Die Erfindung betrifft einen Quarzobertonoszillator mit einem Quarzoszillator, welcher eine Rückkopplungsschleife aufweist, und einem Resonanzverstärker, dessen Amplitudengang im Bereich der Resonanzfrequenz des Resonanzverstärkers eine Überhöhung aufweist und der in die Rückkopplungsschleife des Quarzoszillators geschaltet ist, wobei Signale im Frequenzbereich der nächstniedrigeren Schwingfrequenz(en) in Relation zu Signalen im Frequenzbereich des zu erzeugenden Obertones in der Rückkopplungsschleife, insbesondere in deren Resonanzverstärker, eine solche Phasenverschiebung erhalten, daß der Quarzobertonoszillator auf den Frequenzen der nächstniedrigeren Schwingfrequenz(en) nicht schwingen kann und daß nur ein Schwingen auf der Frequenz des zu erzeugenden Obertones erfolgt.

Derartige Quarzobertonoszillatoren, wie sie beispielsweise aus der Zeitschrift Funkschau, Heft Nr. 21, 1982, Seiten 81 und 82 bekannt sind, weisen meist Resonanzverstärker auf, welche sowohl Kapazitäten wie auch Induktivitäten aufweisen. Die Resonanzfrequenz dieser Verstärker ist dabei so ausgelegt, daß sie mit der Frequenz des gewünschten Obertones des Quarzoszillators zusammenfällt. Es wird also die Überhöhung im Amplitudengang im Bereich der Resonanzfrequenz des Resonanzverstärkers ausgenutzt. Damit die Resonanzfrequenz genau mit dem gewünschten Oberton des Quarzoszillators zusammenfällt, ist ein genauer Abgleich der Resonanzfrequenz des Resonanzverstärkers erforderlich.

Aus der GB-A-1 113 157 ist ein Quarzobertonoszillator bekannt, welcher ein in einer Rückkopplungsschleife vorgesehenes Bandpaßfilter aufweist, das einen solchen Phasengang hat, daß die Phase des gewünschten Obertones unverändert ist und daß die Phase der unerwünschten Obertöne und der Grundschwingung um mehr als 90 Grad verschoben wird.

Ferner ist aus Elektor, Band 9, Nr. 7/8, Juli/August 1983, Seite 7-31 ein Quarzobertonoszillator bekannt, der aus einem emittergekoppelten Quarzmultivibrator besteht, welcher nur Kapazitäten und ohmsche Widerstände in seiner Rückkopplungsschleife zwischen den Kollektor- und den Basis-Anschlüssen der Transistoren aufweist. Der zu erzeugende Oberton ist die dritte Oberwelle des Quarzoszillators.

Es ist Aufgabe der Erfindung, einen weiteren Quarzobertonoszillator der eingangs genannten Art zu schaffen.

Diese Aufgabe ist erfindungsgemäß dadurch gelöst, daß die Resonanzfrequenz des Resonanzverstärkers zwischen der Frequenz des zu erzeugenden Obertones und der nächstniedrigeren Schwingfrequenz des Quarzoszillators liegt.

Bei diesem Quarzoszillator wird also nicht mehr die Überhöhung im Amplitudengang im Bereich der Resonanzfrequenz des Resonanzverstärkers dazu eingesetzt, in diesem Bereich den gewünschten Quarzoberton zu erzeugen. Es wird vielmehr der Phasengang der Rückkopplungsschleife und in dieser insbesondere der des Resonanzverstärkers dazu eingesetzt, den Quarzobertonoszillator auf der Frequenz des gewünschten Obertones schwingen zu lassen. Der dazu erforderliche Phasengang, den die Signale in der Rückkopplungsschleife halten, wird im Regelfalle vorteilhafterweise durch den Resonanzverstärker erfolgen.

Insgesamt muß in der Rückkopplungsschleife, meist im wesentlichen durch den Resonanzverstärker, für Signale im Frequenzbereich der nächstniedrigeren Schwingfrequenz(en) in Relation zu Signalen im Frequenzbereich des zu erzeugenden Obertones eine solche Resonanzverschiebung erfolgen, daß der Quarzobertonoszillator auf den nächstniedrigeren Schwingfrequenzen nicht schwingen kann, daß also für diese die Schwingbedingung nicht mehr erfüllt ist. Dagegen erfolgt für Signalfrequenzen oberhalb der Resonanzfrequenz der Rückkopplungsschleife bzw. des Resonanzverstärkers keine oder nur eine so geringe Phasenverschiebung der Signale, daß der Quarzobertonoszillator auf der Frequenz des zu erzeugenden Obertones schwingen kann, daß für diese Frequenz also die Schwingbedingung erfüllt ist.

Der Hauptvorteil dieses Quarzobertonoszillators liegt darin, daß die Resonanzfrequenz des Resonanzverstärkers nur noch die Bedingung erfüllen muß, daß sie zwischen der Frequenz des zu erzeugenden Obertones und der nächstniedrigeren Schwingfrequenz des Quarzoszillators liegt. Dieses ist aber ein relativ weiter Frequenzbereich, so daß ein Abgleich der Resonanzfrequenz des Resonanzverstärkers auch bei relativ großen Bauteileschwankungen und damit differierender Resonanzfrequenz des Resonanzverstärkers nicht mehr erforderlich ist. Der Quarzobertonoszillator ist damit problemlos integrierbar. Darüber hinaus ergibt sich aus der unterhalb der Resonanzfrequenz des Resonanzverstärkers vorgenommenen Phasenverschiebung um etwa 180 Grad eine sichere Unterdrückung der Grundschwingung des Quarzoszillators.

Nach einer weiteren Ausgestaltung der Erfindung ist vorgesehen, daß Signale im Frequenzbereich des zu erzeugenden Obertones den Resonanzverstärker nahezu ohne Phasenverschiebung passieren und daß Signale im Frequenzbereich der nächstniedrigeren Schwingfrequenz(en) im Resonanzverstärker eine Phasenverschiebung um etwa 180 Grad erhalten. Ist der Quarzoszillator so ausgelegt, daß ohne einen Einsatz des Resonanzverstärkers in der Rückkopplungsschleife die Schwingbedingung für den gewünschten Quarzoberton erfüllt ist, so wird der Resonanzverstärker vorteilhafterweise in der Weise ausgelegt, daß er oberhalb seiner Resonanzfrequenz keine Phasenverschiebung der ihn durchlaufenden Signale erzeugt. Unterhalb der Resonanzfrequenz erfolgt dann jedoch eine Phasenverschiebung um etwa 180 Grad, so daß der Quarzobertonoszillator in diesem Frequenzbereich nicht schwingen kann.

Nach einer weiteren Ausgestaltung der Erfindung ist vorgesehen, daß zur Erzeugung der Resonanz im Resonanzverstärker als passive Bauelemente ausschließlich Kapazitäten und ohmsche Widerstände vorgesehen sind. Zur Erzeugung der gewünschten Phasenverschiebung um 180 Grad genügt ein einfaches RC-Netzwerk, so daß der Quarzobertonoszillator einschließlich dieses RC-Netzwerkes aus den oben beschriebenen Gründen leicht integrierbar ist.

Zur Unterdrückung einer Schwingung des Quarzobertonoszillators auf einer gegenüber der gewünschten Schwingfrequenz nächsthöheren Resonanzfrequenz des Quarzoszillators ist nach einer weiteren Ausgestaltung der Erfindung vorgesehen, daß die Verstärkung des Resonanzverstärkers und gegebenenfalls der Rückkopplungsschleife des Quarzoszillators so ausgelegt ist, daß bei der gegenüber der Frequenz des gewünschten Obertones nächsthöheren Schwingfrequenz des Quarzoszillators in der Rückkopplungsschleife eine Amplitudenverstärkung erfolgt, welche kleiner als eins ist.

Als konkrete, in ihrer Realisierung recht einfache Ausführungsform des erfindungsgemäßen Quarzobertonoszillators ist nach einer weiteren Ausgestaltung vorgesehen, daß als Quarzoszillator ein wenigstens zwei Transistoren aufweisender emittergekoppelter Quarzmultivibrator und als Resonanzverstärker ein Differenzverstärker mit RC-Netzwerk vorgesehen sind, und daß der Differenzverstärker in der Weise als Rückkopplungsnetzwerk des Quarzmultivibrators verschaltet ist, daß ein erster Eingang des Differenzverstärkers mit dem Kollektor des ersten Transistors und ein erster Ausgang mit der Basis des zweiten Transistors verbunden sind und daß ein zweiter Eingang des Differenzverstärkers mit dem Kollektor des zweiten Transistors und ein zweiter Ausgang mit der Basis des ersten Transistors des Quarzmultivibrators verbunden sind.

Ein Ausführungsbeispiel der Erfindung wird anhand der Zeichnung näher erläutert. Es zeigen:
Fig. 1 einen emittergekoppelten Quarzmultivibrator,
Fig. 2 einen Differenzverstärker mit RC-Netzwerk, welcher als Resonanzverstärker dient,
Fig. 3 den über der Frequenz aufgetragenen Amplituden- und Phasengang des Resonanzverstärkers nach Fig. 2 und
Fig. 4 einen Quarzobertonoszillator, welcher eine Zusammenschaltung des Quarzoszillators nach Fig. 1 und des Resonanzverstärkers nach Fig. 2 darstellt.

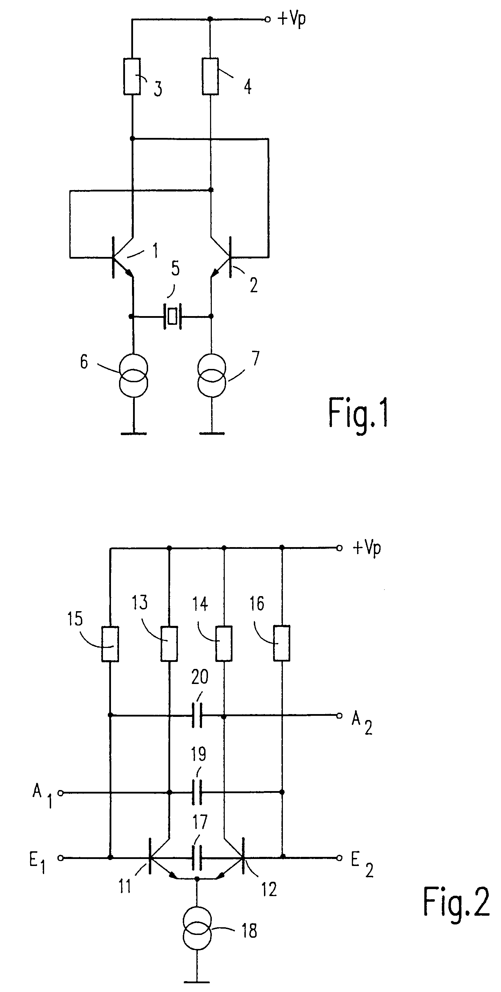

Ein in Fig. 1 dargestellter, emittergekoppelter Quarzmultivibrator weist zwei gegengekoppelte Transistoren 1 und 2 auf, welche jeweils mit ihrem Kollektor über einen ohmschen Widerstand 3 bzw. 4 mit einer positiven Versorgungsspannung + Vp verbunden sind. Die Widerstände 3 und 4 haben die Funktion eines frequenzunabhängigen Rückkopplungsnetzwerkes. Die Basis des Transistors 1 ist mit dem Kollektor des Transistors 2 und umgekehrt die Basis des Transistors 2 mit dem Kollektor des Transistors 1 verbunden. Zwischen die Emitter der beiden Transistoren 1 und 2 ist ein Schwingquarz 5 geschaltet. Ferner sind die beiden Emitter der Transistoren 1 und 2 über je eine Stromquelle 6 bzw. 7 auf Masse geschaltet.

Dieser in Fig. 1 emittergekoppelte Quarzmultivibrator kann beispielsweise 50 ausgelegt sein, daß er auf einer Grundfrequenz von 20 MHz schwingt. Der Quarzmultivibrator kann jedoch auch Schwingungen im Bereich der ungradzahligen Oberwellen erzeugen. Bei einer Grundfrequenz von 20 MHz wären dies für die dritte Oberwelle 60 MHz und für die fünfte Oberwelle 100 MHz.

Soll als gewünschte Obertonfrequenz beispielsweise 60 MHz erzeugt werden, so kann der Quarzoszillator nach Fig. 1 mit einem in Fig. 2 dargestellten Resonanzverstärker in noch näher zu erläuternder Weise zusammengeschaltet werden.

Der in Fig. 2 dargestellte Resonanzverstärker ist als Differenzverstärker aufgebaut, welcher ein RC-Netzwerk zur Erzeugung der Resonanz aufweist.

Der Differenzverstärker nach Fig. 2 weist zwei emittergekoppelte Transistoren 11 und 12 auf. Die Kollektoren der beiden Transistoren 11 und 12 sind über je einen Widerstand 13 bzw. 14 auf eine positive Versorgungsgleichspannung + Vₚ geführt. Die Basen der Transistoren 11 und 12 sind über je einen Widerstand 15 bzw. 16 auf die gleiche Versorgungsspannung geführt. Die Basen der Transistoren 11 und 12 sind über eine Kapazität 17 miteinander gekoppelt. Die miteinander gekoppelten Emitter der Transistoren 11 und 12 sind über eine Stromquelle 18 mit Masse verbunden.

Der Kollektor des Transistors 11, welcher das Signal eines ersten Ausgangs A₁ liefert, ist über eine Koppelkapazität 19 mit der Basis des zweiten Transistors 12 verbunden, welche einen Eingang E₂ darstellt. In entsprechender Weise ist umgekehrt der Kollektor des Transistors 12, der das Signal für einen zweiten Ausgang A₂ liefert, über eine Koppelkapazität 20 mit der Basis des Transistors 11 verbunden, welche einen Eingang E₁ darstellt.

Die Resonanzfrequenz dieses in Fig. 2 dargestellten Resonanzverstärkers wird durch die Werte der Kapazitäten 17, 19 und 20 und der Widerstände 13 und 14 bestimmt. Soll der in Fig. 2 dargestellte Resonanzverstärker mit dem in Fig. 1 dargestellten Quarzoszillator zusammengeschaltet werden und soll ein solcher Quarzobertonoszillator auf der dreifachen Frequenz der Grundwelle des in Fig. 1 dargestellten Quarzoszillators schwingen, so ist die Resonanzfrequenz des in Fig. 2 dargestellten Differenzverstärkers so auszulegen, daß sie zwischen der Grundwelle und der dritten Oberwelle des in Fig. 1 dargestellten Quarzoszillators liegt. In dem oben gewählten Zahlenbeispiel muß die Resonanzfrequenz also im Bereich zwischen 20 und 60 MHz liegen. Damit in dieser Zusammenschaltung ein Schwingen des Quarzoszillators auf seiner Grundwelle sicher unterdrückt wird, weist der in Fig. 2 dargestellte Resonanzverstärker einen Phasengang auf, welcher Signale im Frequenzbereich oberhalb seiner Resonanzfrequenz im wesentlichen ohne Phasenverschiebung passieren läßt, während Signale im Frequenzbereich unterhalb der Resonanzfrequenz des Resonanzverstärkers in ihrer Phase um etwa 180 Grad verschoben werden.

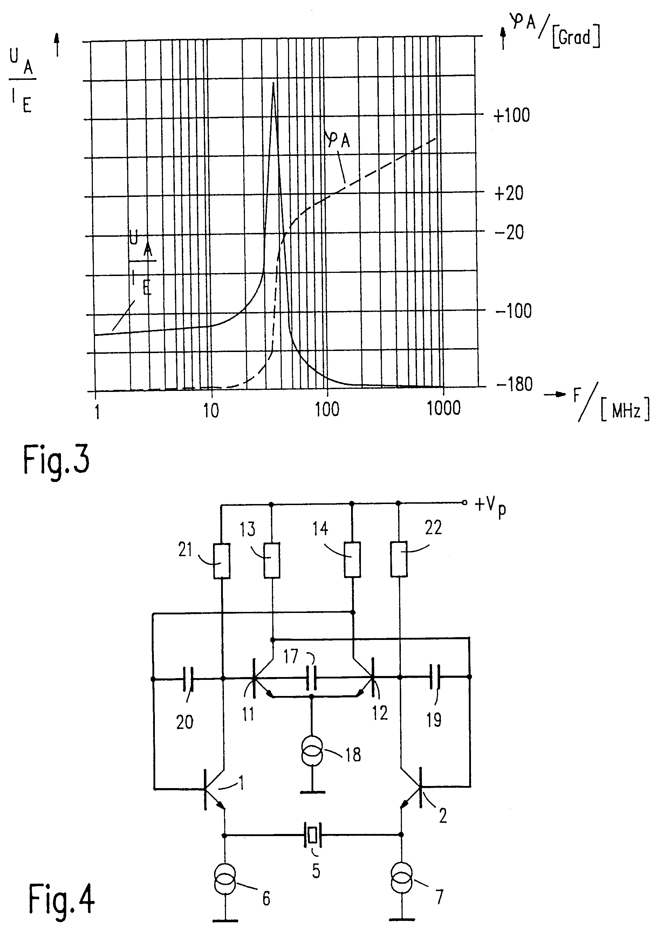

Diese Eigenschaften des in Fig. 2 dargestellten Resonanzverstärkers sind in Fig. 3 näher dargestellt.

Fig. 3 zeigt mittels einer durchgezogenen Linie den über der Frequenz aufgetragenen Amplitudengang des Resonanzverstärkers, sowie in einer gestrichelt eingetragenen Linie dessen Phasengang.

Der in Fig. 3 dargestellte Amplitudengang des Resonanzverstärkers kann in der Weise ermittelt werden, daß in in der Fig. 2 nicht dargestellter Weise eine Stromquelle mit ihren beiden Anschlüssen an die Eingänge E₁ und E₂ des Resonanzverstärkers angeschlossen wird. Zwischen den beiden Ausgängen A₁ und A₂ tritt dann eine Ausgangsspannung U_{A} auf. Das Verhältnis des Stromes, der den beiden Eingängen E₁ und E₂ aufgeprägt ist, zu der Ausgangsspannung, welche zwischen den Klemmen A₁ und A₂ auftritt, ist in der Fig. 3 als Amplitudengang dargestellt. In diesem Amplitudengang ist in der Darstellung gemäß Fig. 3 im Bereich um 38 MHz eine deutliche Überhöhung erkennbar. Es handelt sich hierbei um die Resonanzfrequenz des in Fig. 2 dargestellten Resonanzverstärkers.

Im Bereich dieser Resonanzfrequenz weist der Phasengang φA des Resonanzverstärkers eine deutliche Veränderung auf. Der Phasengang φA bezeichnet dabei die Phasenverschiebung, welche zwischen dem Eingangssignal und dem Ausgangssignal des Differenzverstärkers auftritt. In Fig. 3 ist deutlich, daß unterhalb der Resonanzfrequenz des Resonanzverstärkers eine Phasenverschiebung um etwa 180 Grad erfolgt. Dies gilt somit auch für den Frequenzbereich der Grundwelle des in Fig. 1 dargestellten Quarzoszillators bei etwa 20 MHz. Die Resonanzfrequenz des Resonanzverstärkers nach Fig. 2 ist mit 38 MHz zwischen der Frequenz der Grundwelle des in Fig. 1 dargestellten Quarzoszillators und dessen dritter Oberwelle angesiedelt. Im Bereich der zu erzeugenden Quarzobertonfrequenz, welche hier die dritte Oberwelle darstellt, d.h. also bei etwa 60 MHz, erfolgt im Resonanzverstärker im wesentlichen keine Phasenverschiebung, d.h. also der Phasengang φA weist je einen Wert von etwa 0 Grad auf. Auch im Frequenzbereich der nächsthöheren Oberwelle des Quarzoszillators, d.h. also bei etwa 100 MHz erfolgt nur eine geringfügige Phasenverschiebung der den Resonanzverstärker durchlaufenden Signale.

Aufgrund dieser Auslegung des in Fig. 2 dargestellten Resonanzverstärkers ist also die Vorschrift erfüllt, daß die Signale im Frequenzbereich des zu erzeugenden Obertones, welche im vorliegenden Beispiel die dritte Oberwelle mit einer Frequenz von etwa 60 MHz darstellt, der Resonanzverstärker nahezu keine Phasenverschiebung der ihn durchlaufenden Signale erzeugt. Im Bereich der nächstniedrigeren Schwingfrequenz, welche hier die Grundwelle mit einer Frequenz von etwa 20 MHz darstellt, werden dagegen die den Resonanzverstärker durchlaufenden Signale in ihrer Phase um etwa 180 Grad verschoben, so daß ein Schwingen des Quarzoszillators in diesem Bereich unterdrückt wird. Ein aus dem emittergekoppelten Quarzmultivibrator gemäß Fig. 1 und dem Resonanzverstärker gemäß Fig. 2 aufgebauter Quarzobertonoszillator ist in Fig. 4 dargestellt.

Der in Fig. 1 dargestellte Quarzoszillator weist ein Rückkopplungsnetzwerk auf, das u.a. aus den Widerständen 3 und 4 besteht. Es handelt sich hierbei um ein frequenzunabhängiges Rückkopplungsnetzwerk.

Bei der in Fig. 4 dargestellten Zusammenschaltung des Quarzmultivibrators gemäß Fig. 1 und des Resonanzverstärkers gemäß Fig. 2 entfällt nun das Rückkopplungsnetzwerk des Quarzmultivibrators gemäß Fig. 1. Als Rückkopplungsnetzwerk dient nunmehr der Resonanzverstärker gemäß Fig. 2. Dazu ist der Resonanzverstärker mit seinem ersten Eingang E₁ mit dem Kollektor des ersten Transistors 1 des Quarzmultivibrators verbunden. Der dem ersten Eingang E₁ zugeordnete Ausgang A₁ ist mit der Basis des zweiten Transistors 2 des Quarzmultivibrators verbunden. In entsprechender Weise ist der zweite Eingang E₂ des Resonanzverstärkers mit dem Kollektor des zweiten Transistors 2 des Quarzmultivibrators und der dem zweiten Eingang E₂ zugeordnete Ausgang A₂ mit der Basis des ersten Transistors 1 des Quarzmultivibrators verbunden. Die beiden Widerstände 3 und 4, sowie diejenigen Verbindungen zwischen den beiden Transistoren 1 und 2 des Quarzmultivibrators, welche jeweils eine Basis eines Transistors mit dem Kollektor des anderen Transistors verbanden, sind fortgefallen. Anstelle dieses Rückkopplungsnetzwerkes ist nunmehr der Differenzverstärker getreten.

Der in Fig. 4 dargestellte Quarzobertonoszillator kann im Bereich der Grundwelle seines Quarzoszillators nicht schwingen, da in diesem Bereich, in dem in den Rückkopplungszweig des Quarzoszillators geschalteten Resonanzverstärker eine Phasenverschiebung der diesen durchlaufenden Signale um etwa 180 Grad erfolgt. Im Bereich der dritten Oberwelle, d.h. also bei etwa 60 MHz kann der Quarzobertonoszillator nach Fig. 4 jedoch schwingen, da in diesem Bereich die Rückkopplungssignale den Differenzverstärker im wesentlichen ohne Phasenverschiebung durchlaufen und darüber hinaus in ihrem Pegel nicht zu sehr abgeschwächt werden.

Im Bereich der nächsten Oberwelle, welche bei etwa 100 MHz liegt, findet zwar auch nur eine geringfügige Phasenverschiebung der den Resonanzverstärker durchlaufenden Signale statt, in diesem Frequenzbereich ist jedoch die Amplitude der den Resonanzverstärker verlassenden Signale so gering, daß ein Schwingen des Quarzobertonoszillators bei entsprechender Dimensionierung nicht mehr stattfindet.

Somit ist also sichergestellt, daß der in Fig. 4 dargestellte Quarzobertonoszillator ausschließlich auf seiner dritten Oberwelle bei 60 MHz schwingen kann.

## Patentansprüche

1. Quarzobertonoszillator mit einem Quarzoszillator, welcher eine Rückkopplungsschleife aufweist, und einem Resonanzverstärker, dessen Amplitudengang im Bereich der Resonanzfrequenz des Resonanzverstärkers eine Überhöhung aufweist und der in die Rückkopplungsschleife des Quarzoszillators geschaltet ist, wobei Signale im Frequenzbereich der nächstniedrigeren Schwingfrequenz(en) in Relation zu Signalen im Frequenzbereich des zu erzeugenden Obertones in der Rückkopplungsschleife, insbesondere in deren Resonanzverstärker, eine solche Phasenverschiebung erhalten, daß der Quarzobertonoszillator auf den Frequenzen der nächstniedrigeren Schwingfrequenz(en) nicht schwingen kann und daß nur ein Schwingen auf der Frequenz des zu erzeugenden Obertones erfolgt,
dadurch gekennzeichnet, daß die Resonanzfrequenz des Resonanzverstärkers zwischen der Frequenz des zu erzeugenden Obertones und der nächstniedrigeren Schwingfrequenz des Quarzoszillators liegt.

2. Quarzobertonoszillator nach Anspruch 1,
dadurch gekennzeichnet, daß Signale im Frequenzbereich des zu erzeugenden Obertones den Resonanzverstärker nahezu ohne Phasenverschiebung passieren und daß Signale im Frequenzbereich der nächstniedrigeren Schwingfrequenz(en) im Resonanzverstärker eine Phasenverschiebung um etwa 180 Grad erhalten.

3. Quarzobertonoszillator nach Anspruch 1 oder 2,
dadurch gekennzeichnet, daß der zu erzeugende Oberton die dritte Oberwelle des Quarzoszillators ist und daß die Resonanzfrequenz des Resonanzverstärkers zwischen der Grundwelle und der dritten Oberwelle des Quarzoszillators liegt.

4. Quarzobertonoszillator nach einem der Ansprüche 1 bis 3,
dadurch gekennzeichnet, daß zur Erzeugung der Resonanz im Resonanzverstärker als passive Bauelemente ausschließlich Kapazitäten (17) und ohmsche Widerstände (13, 14) vorgesehen sind.

5. Quarzobertonoszillator nach einem der Ansprüche 1 bis 4,
dadurch gekennzeichnet, daß die Verstärkung des Resonanzverstärkers und gegebenenfalls der Rückkopplungsschleife des Quarzoszillators so ausgelegt ist, daß bei der gegenüber der Frequenz des gewünschten Obertones nächsthöheren Schwingfrequenz des Quarzoszillators in der Rückkopplungsschleife eine Amplitudenverstärkung erfolgt, welche kleiner als eins ist.

6. Quarzobertonoszillator nach einem der Ansprüche bis 5,
dadurch gekennzeichnet, daß als Quarzoszillator ein wenigstens zwei Transistoren (1, 2) aufweisender emittergekoppelter Quarzmultivibrator und als Resonanzverstärker ein Differenzverstärker mit RC-Netzwerk vorgesehen sind, und daß der Differenzverstärker in der Weise als Rückkopplungsnetzwerk des Quarzmultivibrators verschaltet ist, daß ein erster Eingang (E₁) des Differenzverstärkers mit dem Kollektor des ersten Transistors (1) und ein erster Ausgang (A₁) mit der Basis des zweiten Transistors (2) verbunden sind und daß ein zweiter Eingang (E₂) des Differenzverstärkers mit dem Kollektor des zweiten Transistors (2) und ein zweiter Ausgang (A₂) mit der Basis des ersten Transistors (1) des Quarzmultivibrators verbunden sind.

## Claims

1. A harmonic crystal oscillator, comprising a crystal oscillator having a feedback loop and a resonance amplifier whose amplitude characteristic has an overshoot in the range of the resonance frequency of the resonance amplifier and which is arranged in the feedback loop of the crystal oscillator, signals in the range of the next-lower oscillation frequency (frequencies) in relation to signals in the frequency range of the harmonic to be generated in the feedback loop, particularly in the resonance amplifier, being phase shift ed so that the harmonic crystal oscillator cannot oscillate at the frequencies of the next-lower oscillation frequency (frequencies) and that oscillation takes place only at the frequency of the harmonic to be generated, characterized in that the resonant frequency of the resonance amplifier is between the frequency of the harmonic to be generated and the next-lower oscillation frequency of the crystal oscillator.

2. A harmonic crystal oscillator as claimed in Claim 1, characterized in that signals in'the frequency range of the harmonic to be generated pass the resonance amplifier substantially without any phase shift and signals in the frequency range of the next-lower oscillation frequency (frequencies) are subjected to a phase shift of approximately 180 degrees in the resonance amplifier.

3. A harmonic crystal oscillator as claimed in Claim 1 or 2, characterized in that the harmonic to be generated is the third harmonic of the crystal oscillator and in that the resonant frequency of the resonance amplifier is between the fundamental harmonic and the third harmonic of the crystal oscillator.

4. A harmonic crystal oscillator as claimed in any one of the Claims 1 to 3, characterized in that only capacitances (17) and ohmic resistors (13, 14) are provided as passive components for generating the resonance in the resonance amplifier.

5. A harmonic crystal oscillator as claimed in any one of the Claims 1 to 4, charaterized in that the resonance amplifier, and possibly the feedback loop of the crystal oscillator, has such a gain that at the next-higher oscillation frequency of the crystal oscillator, relative to the frequency of the desired harmonic an amplitude gain which is smaller than one occurs in the feedback loop.

6. A harmonic crystal oscillator as claimed in any one of the Claims 1 to 5, characterized in that an emitter-coupled crystal multivibrator comprising at least two transistors (1, 2) is arranged as a crystal oscillator and a differential amplifier with an RC network is arranged as a feedback network of the crystal multivibrator in such a way that a first input (E₁) of the differential amplifier is connected to the collector of the first transistor (1) and a first output (A₁) is connected to the base of the second transistor (2), and in that a second input (E₂) of the differential amplifier is connected to the collector of the second transistor (2) and a second output (A₂) is connected to the base of the first transistor (1) of the crystal multivibrator.

## Revendications

1. Oscillateur harmonique à quartz comprenant un oscillateur à quartz pourvu d'une boucle de réaction et un amplificateur de résonance dont la courbe d'amplitude présente un pic dans le domaine de la fréquence de résonance de l'amplificateur de résonance et qui est branché dans la boucle de réaction de l'oscillateur à quartz, les signaux qui se situent dans le domaine de la ou des fréquences d'oscillation immédiatement plus basses par rapport aux signaux du domaine de fréquences de l'harmonique à produire étant soumis, dans la boucle de réaction, en particulier dans son amplificateur de résonance, à un décalage de phase tel que l'oscillateur harmonique à quartz ne puisse pas osciller sur la ou les fréquences d'oscillation immédiatement plus basses et qu'il ne se produise qu'une oscillation sur la fréquence de l'harmonique à produire, caractérisé en ce que la fréquence de résonance de l'amplificateur de résonance se situe entre la fréquence de l'harmonique à produire et la fréquence d'oscillation immédiatement plus basse de l'oscillateur à quartz.

2. Oscillateur harmonique à quartz selon la revendication 1, caractérisé en ce que les signaux qui se trouvent dans le domaine de fréquences de l'harmonique à produire traversent l'amplificateur de résonance presque sans décalage de phase et que les signaux qui se trouvent dans le domaine de la ou des fréquences d'oscillation immédiatement plus basses sont soumis dans l'amplificateur de résonance à un décalage de phase d'environ 180°.

3. Oscillateur harmonique à quartz selon la revendication 1 ou 2, caractérisé en ce que l'harmonique à produire est le troisième harmonique de l'oscillateur à quartz et la fréquence de résonance de l'amplificateur de résonance se situe entre l'onde fondamentale et le troisième harmonique de l'oscillateur à quartz.

4. Oscillateur harmonique à quartz selon l'une quelconque des revendications 1 à 3, caractérisé en ce que, pour produire la résonance dans l'amplificateur de résonance, à titre de composants passifs sont prévues exclusivement des capacités (17) et des résistances ohmiques (13, 14).

5. Oscillateur harmonique à quartz selon l'une quelconque des revendications 1 à 4, caractérisé en ce que l'amplification de l'amplificateur de résonance et, éventuellement, de la boucle de réaction de l'oscillateur à quartz est étudiée de telle sorte qu'il se produise pour la fréquence d'oscillation de l'oscillateur à quartz immédiatement supérieure à la fréquence de l'harmonique souhaité, dans la boucle de réaction, une amplification d'amplitude inférieure à 1.

6. Oscillateur harmonique à quartz selon l'une quelconque des revendications 1 à 5, caractérisé en ce qu'on utilise comme oscillateur à quartz un multivibrateur à quartz à couplage d'émetteur, comportant au moins deux transistors (1, 2), et, comme amplificateur de résonance, un amplificateur différentiel à réseau RC, et on connecte l'amplificateur différentiel comme réseau de réaction du multivibrateur à quartz de manière qu'une première entrée (E1) de l'amplificateur différentiel soit connectée au collecteur du premier transistor (1) et une première sortie (A1), à la base du second transistor (2), et qu'une seconde entrée (E2) de l'amplificateur différentiel soit connectée au collecteur du second transistor (2) et une seconde sortie (A2), à la base du premier transistor (1) du multivibrateur à quartz.
